# DEMANDE DE BREVET EUROPEEN

(11) **EP 0 656 657 A1**
(43) Date de publication de la demande: **07.06.1995**
(21) Numéro de dépôt: 94402739.0
(22) Date de dépôt: 30.11.1994
(51) Int. Cl.: H01L 23/522, H01L 29/94

(54) **Dispositif de réduction du niveau de bruit d'un circuit intégré à plusieurs niveaux de conducteurs**

(30) Priorité: 01.12.1993 FR 9314389
(71) Demandeur: MATRA MHS, F-44087 Nantes Cédex 03 (FR)
(72) Inventeur: Beyron, Bruno, F-44390 Niort/Erdre (FR)
(74) Mandataire: Fréchède, Michel

(57) **Abrégé**

L'invention concerne un dispositif de réduction du niveau de bruit d'un circuit intégré à plusieurs niveaux de conducteurs. Le dispositif comprend au moins une capacité électrique (1 à 5) reliant deux lignes d'alimentation de niveaux de conducteurs distincts ou non. La capacité peut être une capacité de stockage de charges électriques permettant de répondre à des appels de courants électriques locaux pour diminuer les chutes de tension sur les résistances parasites et/ou une capacité de couplage des lignes d'alimentation, ce qui permet de conjuguer le bruit entre les lignes d'alimentation et de distribuer l'énergie de bruit sur l'ensemble du circuit.

## Description

Dans les circuits intégrés, de type CMOS notamment, il est usuel, compte tenu du très large niveau d'intégration habituellement pratiqué, de réaliser l'alimentation en énergie électrique des différents éléments fonctionnels intégrés au moyen de plusieurs niveaux de conducteurs destinés à porter pour partie ces éléments à un potentiel électrique de valeur fixe déterminée. Le plus souvent, ces potentiels électriques sont constitués par le potentiel électrique de la source d'alimentation électrique, actuellement de valeur égale à 5V ou à 3V et le potentiel de référence.

De la fixité des valeurs de ces potentiels électriques en fonctionnement dépendent dans une large mesure les performances réelles des circuits intégrés précités, quelle que soit la fonction réalisée par ces derniers.

Cette fixité n'est, au cours du fonctionnement, jamais totalement atteinte, en raison des phénomènes de bruit électrique provenant des commutations à l'intérieur même des circuits intégrés, bruit en particulier lié à la self-inductance parasite des boîtiers des circuits intégrés, au micro-câblage (bonding) ainsi qu'aux lignes d'alimentation de ces circuits.

En outre, la taille actuelle de ces circuits par rapport à l'actuelle densité des réseaux de lignes d'alimentation fait que le bruit des alimentations se propage de manière quasi-instantanée sur l'ensemble des fonctions logiques réalisées par les éléments intégrés du circuit intégré.

Ainsi, un circuit intégré bruité par sa tension d'alimentation restitue le bruit, les niveaux logiques ou analogiques émis par celui-ci étant ainsi faussés, ce qui provoque de sérieuses difficultés de dialogue entre circuits intégrés successifs, ceux-ci ne reconnaissant plus leurs niveaux de tension respectifs.

Les solutions classiques utilisées à ce jour consistaient, d'une part, à utiliser des alimentations stabilisées performantes pour lesquelles la tension de sortie d'alimentation continue est stabilisée avec un taux de variation inférieur à 0,5 à 1% maximum de la valeur nominale, et, d'autre part, à munir les circuits intégrés alimentés de capacités de découplage internes ou externes entre la tension d'alimentation et la tension de référence, dite tension de masse.

L'alimentation à partir d'une alimentation stabilisée efficace ne peut être envisagée que dans le cadre expérimental, et en aucun cas en milieu industriel ou dans des conditions de fonctionnement extrêmes.
En outre, le découplage des capacités n'est pas totalamaent efficace en raison du fait que la tension de masse n'est jamais parfaitement une tension de référence absolue, en raison des nombreuses résistances parasites inéluctablement présentes sur les circuits de masse précités.

La présente invention a pour but de remédier aux inconvénients précités, par la mise en oeuvre d'un dispositif de réduction du niveau de bruit d'un circuit intégré à plusieurs niveaux de conducteurs permettant de répondre instantanément à des appels locaux de courants électriques, ce qui permet de diminuer les chutes de tension sur les résistances parasites présentes sur les circuits des lignes d'alimentation et de masse des circuits intégrés.

Un autre objet de la présente invention est la mise en oeuvre d'un dispositif de réduction du niveau de bruit d'un circuit intégré permettant de provoquer un couplage électrique maximum entre les lignes d'alimentation de ce circuit intégré, de façon à transférer de manière instantanée toute variation intempestive de tension d'alimentation, et à rendre le niveau de bruit électrique semblable, ce qui permet de s'affranchir de toute perturbation de bruit électrique, même en présence d'une ligne de masse imparfaite.

Le dispositif de réduction du niveau de bruit d'un circuit intégré à plusieurs niveaux de conducteurs, chaque niveau de conducteurs comportant au moins une ligne d'alimentation en tension continue, conforme à l'objet de la présente invention, est remarquable en ce qu'il comprend au moins une capacité électrique reliant deux lignes d'alimentation de niveaux de conducteurs distincts ou non.

Le dispositif de réduction du niveau de bruit d'un circuit intégré à plusieurs niveaux de conducteurs, objet de l'invention, trouve son application à l'industrie des circuits intégrés, notamment dans un réseau de portes.

Une description plus détaillée du dispositif objet de la présente invention sera donnée ci-après en liaison avec les dessins dans lesquels :

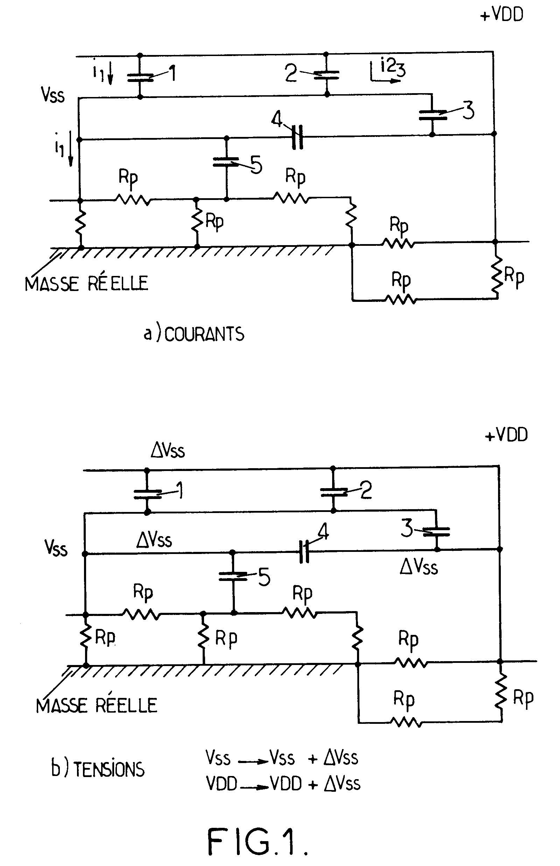

- la figure 1 au point a) représente un schéma de principe du dispositif objet de la présente invention, sous forme de schéma équivalent, dans un premier mode opératoire ;
- la figure 1 au point b) représente un schéma de principe du dispositif objet de la présente invention, sous forme de schéma équivalent, dans un deuxième mode opératoire ;
- la figure 2a représente, selon une vue de dessus, un mode de réalisation avantageux du dispositif selon l'invention dans le cas d'un circuit intégré de type CMOS ;
- la figure 2b représente une vue en coupe selon le plan de coupe PP de la figure 2a ;
- la figure 3a représente, selon une vue en coupe longitudinale, une première cellule d'alimentation d'un circuit intégré comportant un dispositif de réduction du niveau de bruit conforme à l'objet de la présente invention ;
- la figure 3b représente, selon une vue en coupe longitudinale, une deuxième cellule d'alimentation d'un circuit intégré adjacente à la première cellule dans une direction transversale à cette direction longitudinale ;
- la figure 4a représente une vue en plan d'un dispositif objet de la présente invention dans un mode de réalisation préférentiel dans lequel un système d'anneaux de garde a été introduit ;
- la figure 4b représente une vue partielle en coupe selon le plan de coupe QQ de la figure 4a.

Une description plus détaillée du dispositif de réduction du niveau de bruit d'un circuit intégré à plusieurs niveaux de conducteurs conforme à l'objet de la présente invention sera maintenant décrit en liaison avec les figures 1a, 1b et suivantes.

Ainsi qu'on l'a représenté sur les figures 1a et 1b, le dispositif de réduction du niveau de bruit d'un circuit intégré à plusieurs niveaux de conducteurs est préférentiellement disposé dans un circuit intégré dans lequel chaque niveau de conducteurs comporte au moins une ligne d'alimentation électrique en tension continue. Ces lignes d'alimentation électrique en tension continue sont des lignes permettant d'amener par exemple une tension de valeur positive, notée +VDD ou une tension de référence notée VSS. Les tensions précitées correspondent par exemple aux tensions de drain et de source dans un circuit intégré de type CMOS par exemple.

Ainsi qu'on l'observera sur les figures 1a et 1b, le dispositif objet de la présente invention comprend au moins une capacité électrique reliant deux lignes d'alimentation de niveaux de conducteurs disctincts ou non. Sur la figure 1a et la figure 1b, par exemple, les capacités électriques sont notées 1, 2, 3, 4 et 5, ces capacités assurant la liaison entre les conducteurs portés au potentiel +VDD respectivement au potentiel VSS.

De préférence, ainsi que représenté notamment sur la figure 1a, les capacités utilisées sont des capacités de stockage de charges électriques permettant de répondre à des appels de courants électriques locaux. On comprend bien sûr que dans un tel cas, les capacités de stockage sont des capacités reliant deux lignes à des tensions différentes +VDD et VSS, ce qui permet de charger la capacité correspondante à une tension de charge correspondant à VDD - VSS afin de répondre aux appels de courants électriques locaux précédemment mentionnés. C'est en particulier le cas pour les capacités 1, 2, 3, 4 pour lesquelles les appels de courants électriques locaux peuvent être compensés par des courants de décharge notés i1, i23 par exemple.

En outre, on constate qu'en raison de l'imperfection de la tension de masse représentée sur la figure 1a ou 1b par l'indication masse réelle, la tension de référence VSS est en fait reliée à la masse réelle par l'intermédiaire de résistances parasites notées Rp dont les valeurs ne sont pas connues de manière précise, toute résistance parasite étant notée par la désignation Rp mais pouvant présenter des valeurs quelconques arbitraires.

En outre, ainsi qu'on l'a représenté en figure 1b, la ou lesdites capacités électriques peuvent être formées par une capacité de couplage des lignes d'alimentation. Ceci est le cas en particulier pour les capacités 4 et 5. Ainsi que représenté sur la figure 1b, toute perturbation intempestive sur l'une ou l'autre des lignes d'alimentation a pour effet de répercuter cette perturbation sur l'autre ligne d'alimentation ou sur une partie distante de la même ligne d'alimentation pour ce qui concerne la capacité 5.

Ansi, pour une perturbation ΔVSS présente sur la ligne d'alimentation VSS, cette perturbation est immédiatement répercutée par la capacité 4 sur la ligne d'alimentation +VDD, ainsi d'ailleurs que par les capacités 1 et 2, la tension instantanée sur cette ligne devenant VDD + ΔVSS. Ce mode opératoire permet ainsi de conjuguer le bruit entre les lignes d'alimentation et de distribuer ainsi l'énergie de bruit sur l'ensemble du circuit.

On comprend bien sûr que, en présence d'une perturbation sur l'une des lignes d'alimentation, la tension passant par exemple de VSS à VSS + ΔVSS, l'autre tension d'alimentation passe instantanément ou quasi-instantanément à la valeur VDD + ΔVSS, la différence entre les deux tensions d'alimentation instantanée étant maintenue sensiblement à la valeur VDD - VSS.

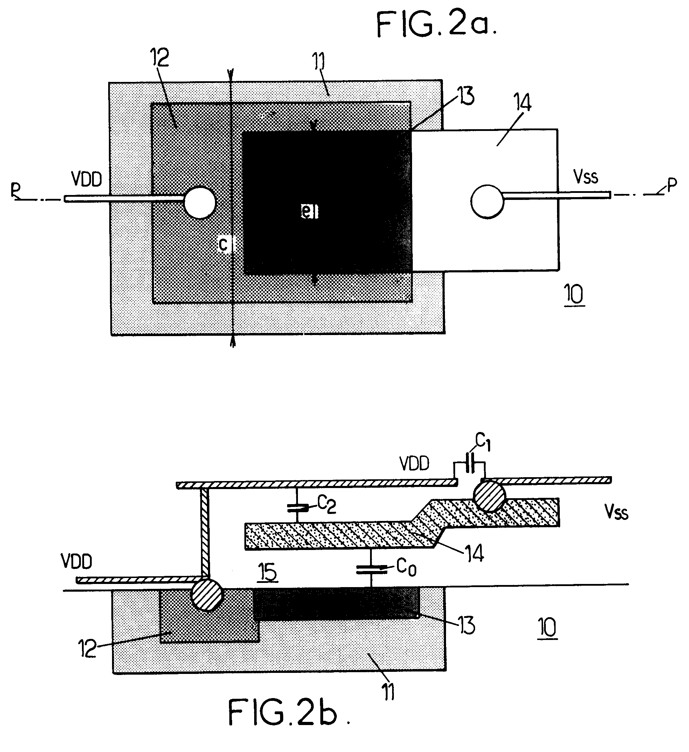

D'une manière générale, on indique que les différentes capacités précitées, dans le cas d'un circuit intégré en technologie MOS, peuvent être intégrées au circuit intégré notamment au niveau de la couche d'oxyde de grille ainsi qu'il sera décrit ci-après en liaison avec les figures 2a et 2b.

Sur les figures précitées, on indique que, de manière non limitative, la technologie MOS est décrite dans le cadre d'un substrat de type P, substrat référencé 10, dans lequel un caisson 11 de type N est implanté. De manière classique, le caisson 11 comporte une prise de polarisation N⁺, notée 12, laquelle est reliée à la tension d'alimentation +VDD.

Selon un aspect particulièrement avantageux du dispositif objet de la présente invention, la ou l'une des capacités électriques reliant deux lignes d'alimentation de niveaux de conducteurs distincts est formée par au moins un transistor virtuel de type MOS intégré au substrat du circuit intégré. Ce ou ces transistors comportent une zone de canal, notée 13, laquelle est implantée dans le caisson 11. Une couche de polysilicium de grille 14 est implantée au-dessus de la couche d'oxyde de grille disposée au-dessus du substrat 10 au niveau de la zone de canal 13. La couche de polysilicium de grille 14, placée en vis-à-vis de la zone de canal 13 du transistor, forme avec celle-ci et avec la couche d'oxyde de grille 15 comprise entre la zone de canal 13 et la couche de polysilicium de grille 14 la capacité électrique précitée. Cette capacité est notée C0 sur la figure 2b. On indique enfin que la couche de polysilicium de grille 14 peut présenter un décrochement en dehors de la zone de canal 13 libérant une zone d'oxyde de champ au dessus du substrat 10, cette partie de la couche de polysilicium de grille 14 étant reliée à la tension d'alimentation VSS.

Ainsi, conformément à un aspect particulièrement avantageux du dispositif objet de la présente invention, celui-ci, par la mise en oeuvre d'un transistor virtuel de type MOS intégré au substrat, permet par exemple en l'absence d'utilisation de la source ou du drain de transistor ainsi créé, celui-ci présentant donc un caractère virtuel, d'engendrer une capacité de forte valeur permettant d'assurer les fonctions de couplage et de libération de courant sur appels de courants locaux ainsi que décrit précédemment dans la description.

Selon un premier aspect particulièrement avantageux du dispositif objet de la présente invention, la zone de canal 13 peut, par rapport à un transistor MOS de type classique, présenter des dimensions spécifiques telles que par exemple une dimension transversale e sensiblement augmentée, ce qui permet d'augmenter d'autant la valeur de la capacité C0 ainsi réalisée par la zone de canal précédemment mentionnée.

En outre, la zone de canal 13 précitée peut être le siège d'une implantation ionique à partir d'ions positifs ou négatifs selon le type de transistor MOS réalisé, une telle implantation spécialisée ayant pour effet d'augmenter encore la capacité présentée par la zone de canal vis-à-vis de la couche de polysilicium de grille 14 ainsi que mentionné précédemment dans la description. Ainsi, pour une dimension transversale c du caisson 11, ainsi que représenté en figure 2a, on indique que la dimension transversale correspondante de la couche de polysilicium de grille 14, dimension e, et en définitive de la zone de canal 13, peut représenter jusqu'à 60 à 140% de la dimension c précédemment citée. La grille peut en effet déborder sur l'oxyde de grille de toute part, du moment que l'on ménage un accès à la prise de polarisation 12.

Enfin, on indique que, dans le but d'augmenter encore les fonctionnalités du dispositif objet de la présente invention, la fonction du transistor créé peut être activée et découplée ou non de celle de la capacité de canal ainsi créée, ce qui permet d'ajouter soit une fonction nouvelle pour le transistor ainsi créé dont le caractère virtuel se limite ainsi à l'utilisation de la capacité de canal ainsi que précédemment mentionné dans la description, soit de renforcer cette capacité.

Ainsi qu'on l'a en outre représenté en figure 2b, les lignes d'alimentation à des tensions continues distinctes VDD respectivement VSS sont couplées électrostatiquement l'une à l'autre par l'intermédiaire de la capacité C1 représentée sur la figure 2b précitée. Ce couplage peut être réalisé par l'intermédiaire d'une ligne portée à la tension VDD ainsi que représenté sur la figure 2b, la distance séparant cette ligne de la ligne d'alimentation à la tension VSS pouvant être amenée à une valeur de l'ordre de 1 micro-mètre.

De même, pour deux lignes d'alimentation à des tensions continues de valeurs distinctes, les valeurs précitées, la couche de polysilicium de grille 14 connectée à l'une des lignes d'alimentation à la tension VSS sur la figure 2b est couplée électrostatiquement à la ligne d'alimentatoin VDD précitée par l'intermédiaire de la capacité C2 par exemple. La distance séparant la ligne d'alimentation VDD de la couche de polysilicium de grille 14 peut être de l'ordre de 2 à 3 micromètres.

En ce qui concerne la réalisation du transistor précité en technologie de type MOS, on indique que, à partir du substrat 10 de type P⁻ une implantation de type N⁻ est effectuée par exemple pour réaliser le caisson 11.

Après préparation de la couche d'oxyde de grille et de la couche d'oxyde de champ 15, ces couches étant obtenues par dépôt d'oxyde à partir du substrat, la couche de polysilicium de grille 14 est implantée au-dessus de la couche d'oxyde de grille, ainsi que représenté en figure 2b.

Un masquage de l'extérieur des zones de prise de polarisation 12, c'est-à-dire de la zone N⁺, 12 sur les figures 2a ou 2b, permet ensuite d'effectuer une implantation ionique dans le caisson de type N 11 en présence de la couche de polysilicium de grille 14 pour réaliser, en l'absence d'implantation ionique effective du fait de la présence de la couche de polysilicium de grille 14, la zone de canal correspondante 13 au droit de la couche de polysilicium de grille 14. Cette opération permet en fait de constituer le transistor virtuel précédemment mentionné dans la description.

Bien entendu, lorsqu'une implantation spécialisée est effectuée, afin d'augmenter la valeur de la capacité C0 ainsi créée, cette implantation spécialisée est réalisée préalablement à l'implantation de la couche de polysilicium de grille 14 afin d'assurer une homogénéité d'implantation totale au niveau de la zone de canal 13, la zone de canal 13 étant effectuée ultérieurement par implantation en présence de la couche d'oxyde de polysilicium de grille 14 ainsi que précédemment mentionné.

Pour la mise en oeuvre du procédé de réalisation du transistor virtuel précité, on indique que les conditions de mode opératoire telles que énergie d'implantation des ions et types d'ions implantés sont connues de l'homme de l'art, et, qu'à ce titre, elles ne sont pas décrites.

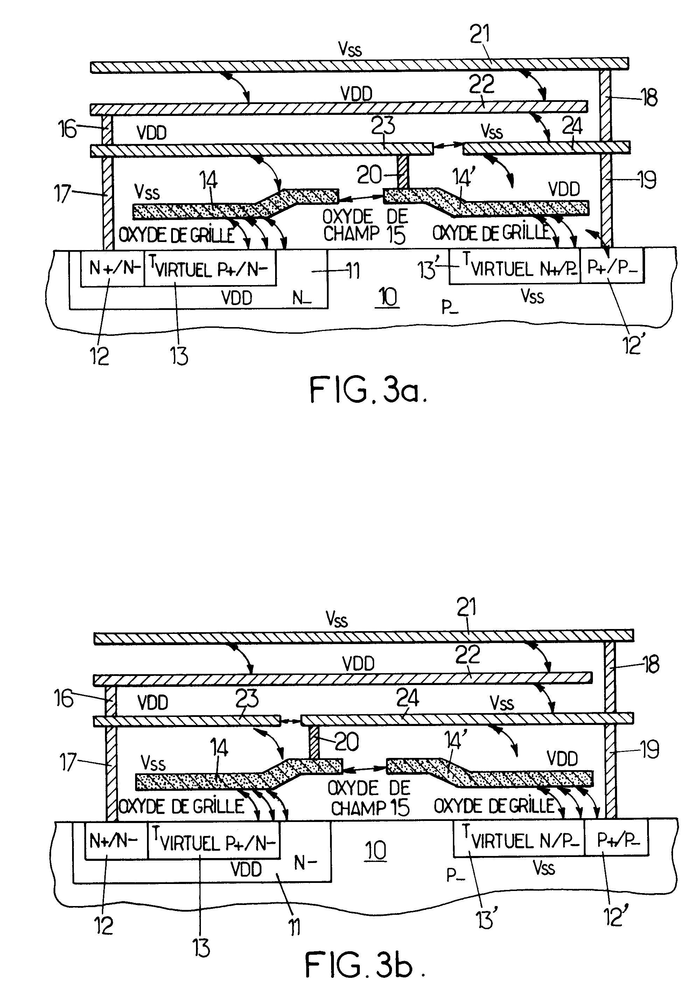

Une description plus détaillée d'un dispositif conforme à l'objet de la présente invention plus spécialement mis en oeuvre sous forme de cellules de réduction de bruit dans les réseaux de portes de circuit intégré sera maintenant donnée en liaison avec les figures 3a et 3b.

D'une manière générale, on indique que chaque cellule est formée sur un substrat 10 de type P⁻, ce substrat comportant de manière identique aux figures 2a et 2b un caisson 11 de type N⁻.

De même, chaque cellule comprend une prise de polarisation 12 de type N⁺/N⁻ et un transistor comportant une zone de canal 13 formant transistor virtuel de type P⁺/N⁻. Le caisson 11 est porté au potentiel VDD par exemple et une couche de polysilicium de grille 14 est formée ainsi que représenté préalablement en figure 2a et 2b.

En outre, le substrat 10 de type P⁻ comporte, pour former la cellule précitée, une deuxième zone de canal, notée 13', formant un deuxième transistor virtuel, cette zone de canal 13' étant de type N⁺/P⁻ et reliée à une prise de polarisation 12' de type P+/P⁻, cette prise de polarisation étant bien entendu reliée à la tension d'alimentation VSS.

En outre, une couche de polysilicium de grille 14' est implantée de manière symétrique à la couche de polysilicium de grille 14, la couche de polysicilium de grille 14' étant portée au potentiel de la ligne d'alimentation VDD et connectée à celle-ci.

Ainsi qu'on l'a représenté en figure 3a et 3b, on indique que, dans une cellule donnée, la couche de polysilicium de grille 14 ou 14' connectée à l'une des lignes d'alimentation VSS respectivement VDD est couplée électrostatiquement à la couche de polysilicium de grille connectée à l'autre ligne d'alimentation VDD, respectivement VSS.

Sur l'ensemble des figures 3a et 3b, les couplages électrostatiques sont représentés par des flèches, le nombre de flèches représentant la valeur relative du couplage électrostatique ainsi formé.

Ainsi qu'on l'observera sur les figures 3a et 3b, les lignes d'alimentation aux potentiels VDD référencées 22, 23 respectivement VSS référencées 21, 24 sont superposées et imbriquées de façon à favoriser d'une part le couplage électrostatique entre les lignes d'alimentation et entre lignes d'alimentation et couches d'oxyde de grille 14 respectivement 14', et d'autre part, entre couches d'oxyde de grille connectées à des lignes d'alimentation à des tensions continues de valeurs distinctes. Les références 16, 17, 18, 19 et 20 désignent les connexions électriques aux lignes d'alimentation respectives.

On comprend bien sûr que les figures 3a et 3b sont des vues en coupe de deux cellules adjacentes selon deux plans parallèles au plan PP de la figure 2a, les deux plans de coupe respectifs des figures 3a et 3b étant distants d'une distance déterminée dans une direction orthogonale au plan PP de la figure 2a, c'est-à-dire dans une direction perpendiculaire aux plans contenant les figures 3a et 3b. On comprend ainsi qu'il existe une certaine continuité dans cette direction, les couches de polysilicium de grille 14 respectivement 14' étant par exemple constituées par une seule et même couche 14-14' dans cette direction pour constituer deux cellules adjacentes.

On comprend ainsi que la superposition et l'imbrication des lignes d'alimentation précitées permet d'assurer un meilleur couplage pour réaliser les fonctions de libération de charges sur appels de courants locaux et de conjugaison des perturbations de bruit ainsi que déjà mentionné dans la description.

Ainsi, sur les figures 3a et 3b, on peut observer que pour un circuit intégré formé sur un substrat de silicium dopé P⁻, celui-ci comprend une pluralité de cellules de réduction du niveau de bruit, chaque cellule pour deux lignes d'alimentation à la première valeur de tension de niveau haut respectivement à la deuxième valeur de tension de niveau bas comportant, outre le caisson dopé N⁻ 11 précédemment mentionné et les prises de polarisation 12, 12' précitées constituant respectivement prise de polarisation de caisson et prise de polarisation de substrat P⁺/P⁻, la prise de polarisation de substrat 12' étant connectée à la ligne d'alimentation à la deuxième tension de niveau bas VSS alors que la prise de polarisation de caisson est reliée à la ligne d'alimentation à la première tension de niveau haut VDD, comprend le transistor virtuel P⁺/N⁻ implanté dans le caisson 11 et comportant la zone de canal 13 ainsi qu'un transistor virtuel N⁺/P⁻ implanté dans le substrat 10 et comportant une zone de canal 13'. Chaque transistor de caisson respectivement de substrat est électriquement relié à la prise de polarisation de caisson 12 respectivement à la prise de polarisation de substrat 12'. En outre, la couche de polysilicium de grille 14 et la couche de polysilicium de grille 14' sont placées chacune en vis-à-vis du transistor virtuel de caisson et du transistor virtuel de substrat respectivement et la couche de polysilicium de grille 14 et la couche de polysilicium de grille 14' sont mutuellement couplées électrostatiquement et connectées chacune à la ligne d'alimentation en tension de niveau bas respectivement à la ligne d'alimentation en tension de niveau haut.

On comprend bien sûr que les cellules de réduction de niveau de bruit sont alors juxtaposées dans la direction perpendiculaire à la direction d'alignement du transistor de caisson et du transistor de substrat. Deux cellules adjacentes sont telles que la connexion de la première et de la deuxième couche de polysilicium 14, 14' à la ligne d'alimentation en tension de niveau bas VSS respectivement à la ligne d'alimentation en tension de niveau haut VDD est effectuée sur une cellule sur deux alternativement.

Ainsi qu'on l'a en outre représenté en figures 3a et 3b, les lignes d'alimentation aux tensions continues distinctes sont superposées dans une direction perpendiculaire au substrat 10 et comportent successivement selon un sens de rapprochement vers la face du substrat comportant les transistors virtuels, une première ligne d'alimentation 21 à la tension de niveau bas VSS s'étendant longitudinalement sur toute la distance couvrant les prises de polarisation de caisson et de substrat 12, 12' ainsi que les transistors virtuels comportant les zones de canal 13, 13'.

Une deuxième ligne d'alimentation 22 à la tension de niveau haut est prévue, celle-ci s'étendant longitudinalement sensiblement sur toute la distance couvrant les prises de polarisation et les transistors virtuels précités. La première 21 et la deuxième 22 ligne d'alimentation sont couplées électrostatiquement, le couplage électrostatique étant représenté par une seule flèche, la distance séparant les deux lignes dans l'oxyde de silicium semblable à l'oxyde de champ étant de l'ordre de quelques micromètres.

Une troisième ligne d'alimentation 23 à la tension de niveau haut et une quatrième ligne d'alimentation 24 à la tension de niveau bas VSS sont prévues, la troisième et la quatrième ligne d'alimentation étant situées au voisinage des couches de polysilicium de grille 14, 14' et étant alignées et mutuellement couplées électrostatiquement. On indique en outre que la quatrième ligne d'alimentation 24 est couplée électrostatiquement à la deuxième ligne d'alimentation 22, le couplage étant symbolisé par une flèche.

Enfin, on indique que la première et la deuxième couche de polysilicium de grille référencées 14, 14' sont connectées à la quatrième 24 respectivement à la troisième 23 ligne d'alimentation précédemment mentionnées alternativement d'une cellule de réduction de bruit à une cellule adjacente.

D'une manière générale, on indique que la périphérie de la matrice de cellules est entourée d'alimentations de taille non négligeable. En outre, selon un aspect avantageux particulier, la matrice de cellules ainsi obtenue peut être entourée d'anneaux de garde par aboutement des zones de prise de polarisation. De plus, une grille métallique peut être réalisée à l'intérieur de la matrice précitée afin de redistribuer les signaux de bruit électrique de manière homogène sur l'ensemble de la matrice.

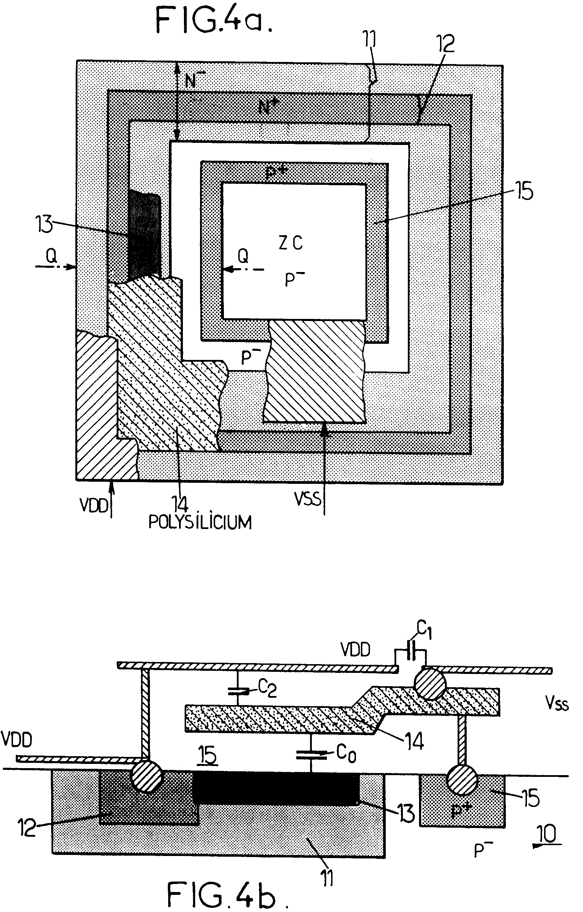

Un mode de réalisation préférentiel du dispositif, objet de la présente invention, sera maintenant décrit en liaison avec les figures 4a et 4b.

Ainsi que représenté sur la figure 4a, laquelle représente une vue en plan d'un dispositif de réduction du niveau de bruit conforme à l'objet de la présente invention lorsque ce dispositif est réalisé sous forme de circuit intégré, on indique que ce dispositif est spécialement adapté pour assurer la réduction du niveau de bruit sur une ou plusieurs zones critiques, notées ZC, du circuit intégré considéré, cette ou ces zones critiques comportant des circuits actifs sensibles ou particulièrement sensibles au bruit. Par convention, sur la figure 4a, la zone critique est notée ZC et elle est réputée constituée par un carré de dimension déterminée comprenant des circuits actifs tels que des transistors ou des circuits logiques ou analogiques directement intégrés dans le circuit intégré.

Conformément à un aspect particulièrement avantageux du dispositif, objet de la présente invention, on indique que la zone critique ZC est entourée par un premier, noté 15, et un deuxième anneau de garde, noté 12, lesquels sont sensiblement concentriques ou au moins non-concourants.

D'une manière générale, on indique que le premier et le deuxième anneau de garde sont reliés à l'une et l'autre ligne d'alimentation, c'est-à-dire à la tension d'alimentation VSS pour le premier anneau de garde 15, respectivement à la tension VDD pour le deuxième anneau de garde 12.

Selon un aspect avantageux du dispositif, objet de la présente invention, on indique que la capacité électrique précédemment décrite dans la description est alors implantée entre le premier 15, et le deuxième anneau de garde 12. Ce mode de réalisation et d'implantation permet de symétriser toute perturbation présente sur l'une et l'autre ligne d'alimentation et, en conséquence, de supprimer la perturbation résultante introduite à l'intérieur de la zone critique par ces mêmes lignes d'alimentation.

D'une manière générale, on indique que l'ensemble du dispositif tel que représenté en figure 4a présente une structure annulaire et l'on comprend en particulier que le premier anneau de garde 15 entourant la zone critique ZC en formant sur la figure 4a une bande fermée en carré, il en est de même pour les éléments du dispositif, objet de la présente invention, tels que représentés préalablement dans la description en figure 2b, dans le mode de réalisation préférentiel des figures 4a et 4b. Ainsi, l'ensemble des éléments tels que les zones d'implantation 11 et 12 formant le caisson et la prise de polarisation ainsi que décrit précédemment, la zone d'implantation 13 formant la zone de canal et, avec la couche de polysilicium de grille 14, la capacité électrique C0 précédemment mentionnée, sont réalisés sous forme annulaire de façon à entourer la zone critique ZC. Bien entendu, les mêmes références représentent les mêmes éléments que dans le cas de la figure 2b, ces éléments étant toutefois distribués de façon annulaire sur la figure 4a.

Dans un mode de réalisation particulier tel que représenté en figures 4a et 4b, la figure 4b représentant une coupe selon le plan de coupe QQ de la figure 4a, pour la zone située à gauche de la zone annulaire représentée par cette figure, on indique que, pour un substrat de silicium dopé de type P⁻, le premier anneau de garde 15 est formé par une zone implantée de type P⁺ fermée, entourant la zone critique ZC. Bien entendu, la zone implantée de type P⁺ 15 est reliée à une des lignes d'alimentation, en l'occurrence la tension de référence ou de masse VSS par exemple.

De même, ainsi que représenté également sur la figure 4b, on indique que, pour le même substrat de silicium dopé de type P⁻, le deuxième anneau de garde 12 est formé par le caisson 11 et la zone de prise de polarisation 12 implantée dans le caisson 11 pour former un caisson de type N⁺/N⁻ précédemment décrit dans la description. Toutefois, ainsi que représenté sur la figure 4a, le caisson précité présente également une forme annulaire et entoure ainsi le premier anneau de garde 15. Le caisson ou, de manière plus précise, la prise de polarisation 12, est alors relié à l'autre ligne d'alimentation, c'est-à-dire à la ligne d'alimentation VDD. On comprend naturellement que, le cas échéant, pour des besoins pratiques, il est possible de relier le premier anneau de garde 15 à la tension VDD et la prise de polarisation 12 à la tension VSS par inversion des tensions d'alimentation.

Compte tenu de l'existence de ce dispositif et en particulier des anneaux de garde précités, on indique que l'effet des perturbations engendrées en dehors de la zone critique ZC sur la zone critique précitée est ainsi atténué, d'une part, par la présence de la capacité C0 précitée, et, d'autre part, par le processus de blindage introduit par les anneaux de garde précédemment mentionnés.

D'une manière générale, on indique que les tensions d'alimentation VDD et VSS peuvent être communes et filtrées par un dispositif de type résistance-capacité ou, au contraire, totalement indépendantes.

Compte tenu de la disposition représentée en figures 4a et 4b, la capacité de couplage C0 des alimentations étant placée entre le premier et le deuxième anneau de garde, un tel mode de réalisation permet une meilleure intégration.

Par le mode de réalisation précité, toute perturbation apparue sur une ligne d'alimentation est transmise intégralement sur l'autre ligne d'alimentation.

Toute perturbation transitoire est ainsi transmise sur les lignes d'alimentation par couplage électrique.

Ainsi, le bruit engendré est propagé par l'intermédiaire des lignes d'alimentation et les signaux d'entrée-sortie à l'intérieur de la zone critique ZC fluctuent en valeur absolue de la même manière et sont donc sensiblement en cohérence.

La distribution locale d'alimentation dans les zones critiques propage alors instantanément les bruits significatifs jusqu'au premier et au deuxième anneau de garde entourant celles-ci. Le couplage électrique transmet les perturbations d'une alimentation sur l'autre et ces perturbations sont redistribuées ainsi jusqu'aux structures sensibles de la zone critique ZC.

Les structures précitées peuvent alors interpréter convenablement les niveaux de sortie des signaux d'entrée, tous les signaux engendrés par les structures de la zone critique devenant équitablement bruités.

La tension de masse VSS utilisée peut alors être celle du substrat du circuit intégré, substrat de type P⁻ dans l'exemple de réalisation donné. Cette tension de masse constitue une bonne référence de tension absolue car le substrat est en général peu résistif et engendre donc de faibles perturbations par chutes ohmiques, alors que le caractère fortement capacitif du substrat permet de constituer un énorme réservoir de charges électriques et offre ainsi une grande inertie aux variations de la valeur de la tension de celui-ci.

Bien entendu, si nécessaire, les anneaux de garde peuvent être ouverts en un ou plusieurs endroits afin de permettre le cas échéant le passage d'un BUS de transmission de signaux vers la zone critique ZC.

On a ainsi décrit un dispositif de réduction du niveau de bruit d'un circuit intégré à plusieurs niveaux de conducteurs particulièrement performant dans la mesure où les phénomènes de couplage en tension et en courant des différents niveaux de conducteurs permettent d'égaliser les perturbations électriques sur l'ensemble de ces niveaux conducteurs, ce qui permet de maintenir une différence de valeurs de tensions sensiblement constante quelle que soit la topographie du circuit.

## Revendications

1. Dispositif de réduction du niveau de bruit d'un circuit intégré à plusieurs niveaux de conducteurs, chaque niveau de conducteurs comportant au moins une ligne d'alimentation électrique en tension continue, une capacité électrique reliant deux lignes d'alimentation de niveaux de conducteurs distincts ou non, caractérisé en ce que, dans le cas d'un circuit intégré en technologie MOS, ladite au moins une capacité électrique est intégrée au circuit intégré au niveau de la couche d'oxyde de grille, et en ce que cette capacité électrique est formée par :
- un transistor virtuel de type MOS intégré au substrat du circuit intégré, ce transistor comportant une zone de canal,
- une couche de polysilicium de grille implantée au dessus de la couche d'oxyde de grille, la couche de polysilicium de grille étant placée en vis-à-vis de la zone de canal dudit transistor et formant avec celle-ci et avec la couche d'oxyde de grille comprise entre ladite zone de canal et la couche de polysilicium de grille ladite capacité électrique, ladite couche de polysilicium de grille étant électriquement connectée à une ligne d'alimentation.

2. Dispositif selon la revendication 1, caractérisé en ce que ladite capacité est une capacité de stockage de charges électriques permettant de répondre à des appels de courants électriques locaux, ce qui permet de diminuer les chutes de tension sur les résistances parasites.

3. Dispositif selon l'une des revendications 1 ou 2, caractérisé en ce que ladite capacité est une capacité de couplage des lignes d'alimentation, ce qui permet de conjuguer le bruit entre lesdites lignes d'alimentation et de distribuer l'énergie de bruit sur l'ensemble du circuit.

4. Dispositif selon la revendication 1, caractérisé en ce que pour deux lignes d'alimentation à des tensions continues de valeurs distinctes, ladite couche de polysilicium de grille connectée à l'une des lignes d'alimentation est couplée électrostatiquement à ladite couche de polysilicium de grille connectée à l'autre ligne d'alimentation.

5. Dispositif selon la revendication 4, caractérisé en ce que lesdites lignes d'alimentation à des tensions continues distinctes sont couplées électrostatiquement l'une à l'autre.

6. Dispositif selon la revendication 5, caractérisé en ce que lesdites lignes d'alimentation sont superposées et imbriquées, de façon à favoriser, d'une part, le couplage électrostatique entre lesdites lignes d'alimentation et entre lignes d'alimentation et couches d'oxyde de grille, et, d'autre part, entre couches d'oxydes de grille connectées à des lignes d'alimentation à des tensions continues de valeurs distinctes.

7. Dispositif selon l'une des revendications 1 à 6, caractérisé en ce que pour un circuit intégré formé sur un substrat de silicium dopé P⁻, celui-ci comprend une pluralité de cellules de réduction du niveau du bruit, chaque cellule pour deux lignes d'alimentation à une première valeur de tension de niveau haut respectivement à une deuxième valeur de tension de niveau bas comportant :
- un caisson dopé N⁻,
- une prise de polarisation de caisson N⁺/N⁻, et
- une prise de polarisation de substrat P⁺/P⁻, la prise de polarisation de caisson étant électriquement connectée à la ligne d'alimentation à la première tension de niveau haut et la prise de polarisation de substrat étant connectée à la ligne d'alimentation à la deuxième tension de niveau bas,
- un transistor virtuel P⁺/N⁻ implanté dans le caisson, et
- un transistor virtuel N⁺/P⁻ implanté dans le substrat, chaque transistor de caisson respectivement de substrat étant électriquement relié à la prise de polarisation de caisson respectivement à la prise de polarisation de substrat,
- une première et une deuxième couche de polysilicium de grille placées chacune en vis-à-vis du transistor virtuel de caisson respectivement de substrat, la première et la deuxième couche de silicium de grille étant mutuellement couplées électrostatiquement et connectées chacune à la ligne d'alimentation en tension de niveau bas respectivement à la ligne d'alimentation en tension de niveau haut.

8. Dispositif selon la revendication 7, caractérisé en ce que lesdites cellules de réduction de niveau de bruit sont juxtaposées dans une direction perpendiculaire à la direction d'alignement du transistor de caisson et du transistor de substrat, deux cellules adjacentes étant telles que la connexion de la première et de la deuxième couche de polysilicium à la ligne d'alimentation en tension de niveau bas respectivement de niveau haut est effectuée sur une cellule sur deux alternativement.

9. Dispositif selon l'une des revendications 6 à 8, caractérisé en ce que lesdites lignes d'alimentation à des tensions continues distinctes sont superposées dans une direction perpendiculaire au substrat, et comportent successivement, selon un sens de rapprochement vers la face du substrat comportant les transistors virtuels,
- une première ligne d'alimentation à la tension de niveau bas s'étendant longitudinalement sur toute la distance couvrant les prises de polarisation de caisson et de substrat et les transistors virtuels,
- une deuxième ligne d'alimentation à la tension de niveau haut, s'étendant longitudinalement sensiblement sur toute la distance couvrant les prises de polarisation et les transistors virtuels, la deuxième et la première ligne d'alimentation étant couplées électrostatiquement,
- une troisième ligne d'alimentation à la tension de niveau haut et une quatrième ligne d'alimentation à la tension de niveau bas, la troisième et la quatrième ligne d'alimentation étant alignées et mutuellement couplées électrostatiquement, ladite quatrième ligne d'alimentation étant couplée électrostatiquement à ladite deuxième ligne d'alimentation.

10. Dispositif selon les revendications 7, 8 et 9, caractérisé en ce que ladite première et ladite deuxième couche de polysilicium de grille sont connectées à la quatrième respectivement la troisième ligne d'alimentation alternativement d'une cellule de réduction de bruit à une cellule adjacente.

11. Dispositif selon l'une des revendications 1 à 10, caractérisé en ce que, pour une zone critique du circuit intégré comportant des circuits actifs sensibles au bruit, ladite zone critique est entourée par un premier et un deuxième anneau de garde sensiblement concentriques, reliés à l'une et l'autre ligne d'alimentation respectivement, ladite capacité électrique étant implantée entre le premier et le deuxième anneau de garde, ce qui permet de symétriser toute perturbation présente sur l'une et l'autre ligne d'alimentation et de supprimer la perturbation résultante à l'intérieur de ladite zone critique.

12. Dispositif selon la revendication 11, caractérisé en ce que pour un substrat de silicium dopé de type P⁻, ledit premier anneau de garde est formé par une zone implantée de type P⁺ fermée, entourant ladite zone critique, ladite zone implantée de type P⁺ étant reliée à une ligne d'alimentation.

13. Dispositif selon l'une des revendications 11 ou 12, caractérisé en ce que pour un substrat de silicium dopé de type P⁻, ledit deuxième anneau de garde est formé par un caisson N⁺/N⁻ entourant ledit premier anneau de garde, ledit caisson étant relié à l'autre ligne d'alimentation.
